# EUROPÄISCHE PATENTANMELDUNG

(11) **EP 1 146 570 A1**
(43) Veröffentlichungstag der Anmeldung: **17.10.2001**
(21) Anmeldenummer: 00108250.2
(22) Anmeldetag: 14.04.2000
(51) Int. Cl.: H01L 33/00, G02B 6/42, H01L 31/0203, H01L 31/0232

(54) **Lichtemittierendes Halbleiterbauelement und Verfahren zur Herstellung eines Trägerelements**

(71) Anmelder: Infineon Technologies AG, 81541 München (DE)
(72) Erfinder: Weigert, Martin, 93152 Hardt (DE); Althaus, Hans-L., 93138 Lappersdorf (DE)
(74) Vertreter: Zedlitz, Peter, Dipl.-Inf.

(57) **Zusammenfassung**

Die Erfindung betrifft ein lichtemittierendes Halbleiterbauelement (1) mit einem lichterzeugenden oder empfangenden aktiven Halbleiterelement (6), bei dem das auszusendende oder zu empfangende Lichtbündel (6a) vermittels einer Lichtkorrektureinrichtung (5 und 7) geformt ist, und das aktive Halbleiterelement auf einer Montage-Oberfläche (2b) eines das Halbleiterelement abstützenden Trägerelements (2) befestigt ist, wobei das Trägerelement (2) aus einem kristallinen Material besteht und die Lichtkorrektureinrichtung (5 und 7) durch von dem auszusendenden oder zu empfangenden Lichtbündel zu durchstrahlenden Ausformungen des Trägerelements (2) selbst gebildet ist. Ferner betrifft die Erfindung ein Verfahren zur Herstellung eines Trägerelements (2) für ein lichtemittierendes oder -empfangendes Halbleiterbauelement (6).

## Beschreibung

Die Erfindung bezieht sich auf ein Lichtemittierendes Halbleiterbauelement mit einem lichterzeugenden oder empfangenden aktiven Halbleiterelement, bei dem das auszusendende oder zu empfangende Lichtbündel vermittels einer Lichtkorrektureinrichtung geformt ist, und das aktive Halbleiterelement auf einer Montage-Oberfläche eines das Halbleiterelement abstützenden Trägerelements befestigt ist.

Lichtemittierende Halbleiterbauelemente, insbesondere Laser-Dioden, beinhalten aktive lichtaussendende Halbleiterelemente, die das Licht in einem großen Raumwinkel oder sogar seitlich oder an der Kante emittieren. Für viele Anwendungen jedoch ist eine gerichtete bzw. fokussierende Abstrahlung des emittierten Lichts in einen kleinen Raumwinkel bzw. nur in eine Richtung erwünscht. Dies ist insbesondere bei Sendern für die optische Datenübertragung und kohärenten Lichtquellen wünschenswert.

Zur Umlenkung und Bündelung bzw. Formung der Lichtbündel kommen Reflektoren und optische Elemente zum Einsatz, die das seitlich und/oder in einem großen Raumwinkel emittierte Licht in eine Hauptabstrahlrichtung bündeln. Bisher wurden solche Reflektoren und optische Elemente durch einzeln ausgebildete Teile gebildet, die auf dem das aktive Halbleiterelement tragenden Trägerelement befestigt und justiert wurden. Nachteilig war hierbei die schwierige Justage der einzelnen Elemente und die teure Herstellungszeit in Anspruch nehmende aufwendige Einzelbestückung. Da die optischen Elemente oft aus verschiedenen Materialien bestehen, wirkt sich deren unterschiedlicher Brechungsindex weiter nachteilig aus.

Weiterhin nachteilig ist, dass bei direkter Befestigung des lichtemittierenden Halbleiterelements auf einem oftmals metallenen Trägerelement die Dauerhaftigkeit der Verbindung durch die unterschiedlichen Wärmeausdehnungseigenschaften des Halbleitermaterials gegenüber dem Metall in seiner Lebensdauer beschränkt ist, beziehungsweise aufwendige Verbindungstechniken notwendig sind.

Aufgabe der Erfindung ist es, eine lichtemittierendes Halbleiterbauelement und ein Verfahren zur Herstellung eines Trägerelements zur Verfügung zu stellen, das einfacher und schneller herzustellen ist und bei dem die oben genannten Nachteile überwunden werden.

Diese Aufgabe wird durch ein lichtemittierendes Halbleiterbauelement nach Anspruch 1 und ein Verfahren zur Herstellung eines Trägerelements nach Anspruch 9 gelöst.

Erfindungsgemäß besteht das Trägerelement aus einem kristallinen, insbesondere einem einkristallinen Material und die Lichtkorrektureinrichtung ist durch von dem auszusendenden oder zu empfangenden Lichtbündel zu durchstrahlenden Ausformungen des Trägerelements selbst gebildet.

Die Erfindung schlägt vor, das Trägerelement des lichtemittierenden Halbleiterbauelements aus einem kristallinen, insbesondere einem einkristallinen Material vorzusehen, wobei die zur Formung und Richtungseinprägung des emittierten beziehungsweise empfangenden Lichtbündels vorgesehenen Elemente einer Lichtkorrektureinrichtung durch Ausformungen des Trägerelements selbst gebildet sind, wobei das Trägerelement selbst beziehungsweise die Lichtkorrektureinrichtung bildenden Ausformungen selbst durchstrahlt werden.

Von Vorteil findet als zu emittierendes oder zu empfangendes Licht Infrarotlicht mit Silizium als Trägermaterial Anwendung. Silizium als Material für die optischen Elemente hat hierbei den Vorteil, dass es einen gegenüber Glas höheren Brechungsindex hat, was den optischen Weg gegenüber Glas verkürzt.

Eine besonders vorteilhafte und daher bevorzugte Ausgestaltung der Erfindung sieht vor, dass die Lichtkorrektureinrichtung ein die emittierten Lichtstrahlen reflektierende und/oder bündelnde Reflektoreinrichtung aufweist. Hierdurch wird in einfachster Weise eine Änderung der Ausbreitungsrichtung des Lichtbündels gewährleistet.

Ebenfalls besonders bevorzugt weist die Lichtkorrektureinrichtung eine die emittierten oder empfangenen Lichtstrahlen formende und/oder bündelnde Lichtbündelformgebungseinrichtung auf. Hierdurch ist eine Fokussierung oder Parallelisierung des emittierten oder empfangenen Lichtbündels ermöglicht. Dem folgend ist von Vorteil die Lichtbündelformgebungseinrichtung eine Linse, insbesondere eine sphärische Linse.

Von Vorteil koppelt die Reflektoreinrichtung das emittierte Lichtbündel in das Material des Trägerelements ein, wobei die Reflektoreinrichtung eine dergestalt angeschrägte Reflektions-Fläche aufweist, dass das Lichtbündel durch das Trägerelement hindurch strahlt.

Von Vorteil ist die Reflektions-Fläche dergestalt geformt, dass das Lichtbündel durch das Trägerelement hindurch und durch die Lichtbündelformgebungseinrichtung strahlt. Hierdurch sind keine weiteren Umlenkspiegel oder dergleichen notwendig und ein weiterer Materialübergang wird vermieden.

Ebenso von Vorteil koppelt die Reflektoreinrichtung das emittierte Lichtbündel in das Material des Trägerelements ein und eine dergestalt geformte Reflektions-Fläche ist vorgesehen, dass das Lichtbündel durch das Trägerelement hindurch strahlt und in seiner Form verändert wird. Durch eine entsprechend geformte Reflektions-Fläche kann hierdurch sogar die Lichtbündelformgebungseinrichtung eingespart werden. Dem folgend hat die Reflektions-Fläche von Vorteil eine elliptische Formgebung.

Eine weitere Ausgestaltung der Erfindung sieht vor, dass die Reflektoreinrichtung eine gegenüber der Montage-Oberfläche angeschrägte Einkoppelfläche aufweist. Hierdurch kann der ungewünschte Reflektionsanteil beim Eintritt des Lichtbündels in die Lichtkorrektureinrichtung minimiert werden.

Von Vorteil weist die angeschrägte Einkoppelfläche und/oder die angeschrägte Reflektionsfläche einen Winkel von 54,74° oder 45° gegenüber der Ausbreitungsrichtung des emittierten Lichtbündels auf.

Eine bevorzugte Ausgestaltung der Erfindung sieht vor, dass die angeschrägte Reflektions-Fläche mit einer den Reflektionsgrad erhöhenden Reflektions-Schicht überzogen ist.

Eine besonders vorteilhafte und daher bevorzugte Ausgestaltung der Erfindung sieht vor, dass das aktive Halbleiterelement eine lichtemittierende Diode, insbesondere eine seiten-und/oder kantenemittierende Laser-Diode ist.

Von Vorteil ist eine auf oder in dem Trägerelement ausgebildete Monitordiode zur Betriebsüberwachung des aktiven Halbleiterelements vorgesehen. Hierdurch können Betriebsstörungen des aktiven Halbleiterelements in dessen direkter Nachbarschaft vereinigt mit dem lichtemittierenden Halbleiterbauelement detektiert werden.

Eine weitere Ausgestaltung der Erfindung sieht vor, dass das Trägerelement aus zwei flächig miteinander verbundenen jeweils Teile der Lichtkorrektureinrichtung aufweisenden Teil-Trägern besteht. Hierdurch ist eine getrennte Prozessierung der Reflektoreinrichtung und der Lichtbündelformgebungseinrichtung ermöglicht, wobei die beiden Teilträger miteinander zum Trägerelement verbunden werden.

Das erfindungsgemäße Verfahren zur Herstellung eines Trägerelements für ein lichtemittierendes oder -empfangendes Halbleiterbauelement sieht vor, dass aus dem Material des Trägerelements eine gegenüber der Oberfläche des Trägerelements aufragende und/oder in die Oberfläche des Trägerelements hineinragende und von dem emittierenden oder -empfangenen Lichtbündel zu durchstrahlende Lichtkorrektureinrichtung ausgeformt wird.

Ein besonders vorteilhafter und daher bevorzugter Verfahrensschritt sieht vor, dass die die Lichtkorrektureinrichtung bildenden Ausformungen durch bereichsweises Wegätzen eines Grundträgers, insbesondere einer zwei planparallele Seiten aufweisenden Platte oder Scheibe, vermittels eines nasschemischen Ätzprozesses und/oder eines reaktiven Ionen-Ätz-Prozesses hergestellt werden. Hierdurch kann in besonders einfacher Weise, beispielsweise aus einem Wafer, gleichzeitig eine große Anzahl Träger mit Lichtkorrektureinrichtung, die aus Ausformungen des Trägermaterials selbst gebildet ist, hergestellt werden.

Ein weiterer vorteilhafter Verfahrensschritt sieht vor, dass die Oberfläche der Lichtkorrektureinrichtung wenigstens teilweise mit einer den Reflektionsgrad erhöhenden Reflektions-schicht insbesondere aus Metall oder mehreren dielektrischen Schichten überzogen wird.

Weitere Vorteile, Besonderheiten und zweckmäßige Weiterbildungen der Erfindung ergeben sich aus den weiteren Unteransprüchen.

Nachfolgend wird die Erfindung anhand der Zeichnung weiter erläutert. Im Einzelnen zeigen die schematischen Darstellungen in:
- Figur 1: eine schematische Querschnitts-Darstellung eines bevorzugten Ausführungsbeispieles eines erfindungs- gemäßen lichtemittierenden Halbleiterbauelements mit einer in einem kristallinen Trägerelement aus- gebildeten Lichtkorrektureinrichtung und einem ak- tiven Halbleiterelement;
- Figur 2: eine schematische Querschnitts-Darstellung eines Trägerelements eines lichtemittierenden Halbleiter- bauelements mit einer Lichtkorrektureinrichtung;
- Figur 3: eine schematische Querschnitts-Darstellung eines weiteren Ausführungsbeispieles eines erfindungsge- mäßen lichtemittierenden Halbleiterbauelements mit einer nahe der Montageebene emittierenden Diode;
- Figur 4: eine schematische Querschnitts-Darstellung eines weiteren Ausführungsbeispieles eines erfindungsge- mäßen lichtemittierenden Halbleiterbauelements mit noch zu verbindenden Teil-Trägern;
- Figur 5: eine schematische Querschnitts-Darstellung eines weiteren Ausführungsbeispieles eines erfindungsge- mäßen lichtemittierenden Halbleiterbauelements mit einer Reflektoreinrichtung mit einer elliptischen oder parabolischen Formgebung;
- Figur 6: eine schematische Querschnitts-Darstellung eines weiteren Ausführungsbeispieles eines erfindungsge- mäßen lichtemittierenden Halbleiterbauelements mit einer angeschrägten Einkoppelfläche; und
- Figur 7: eine schematische Querschnitts-Darstellung eines weiteren Ausführungsbeispieles eines erfindungsge- mäßen lichtemittierenden Halbleiterbauelements ei-
ner von einem Umhüllungsteil gebildeten Reflek- toreinrichtung.

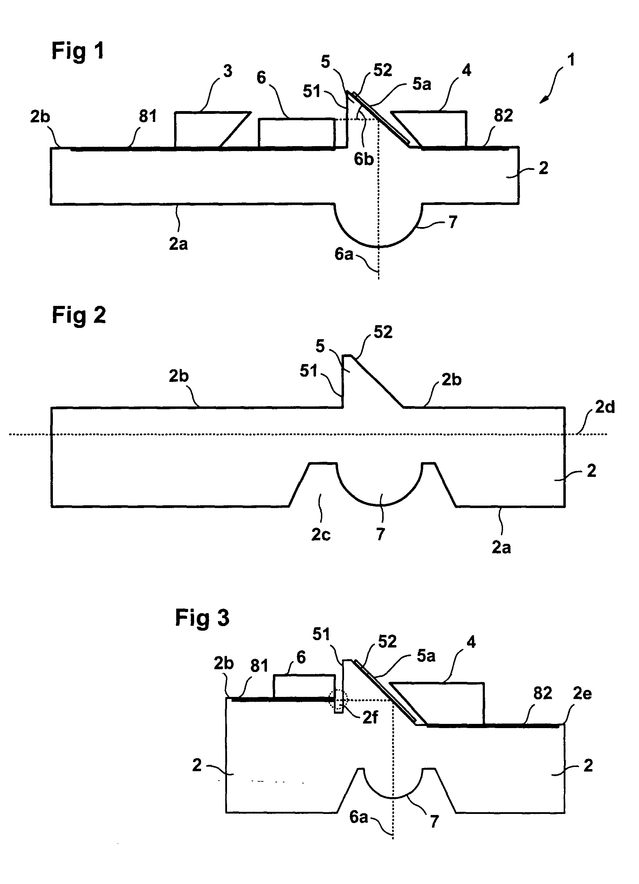

In den Figuren 1 bis 7 gleiche Bezugszeichen bezeichnen gleiche oder gleich wirkende Elemente.

Figur 1 zeigt einen Querschnitt durch ein erfindungsgemäßes lichtemittierendes Halbleiterbauelement 1. Das Halbleiterbauelement weist ein Trägerelement 2 auf dessen Montage-Seite 2b auf einer Leiterschicht 81 eine kantenemittierende Laserdiode 6 montiert ist, zur Betriebsüberwachung der Laserdiode 6 ist eine schräg angeschnittene Monitordiode 3 oder 4 (alternativ), zum Teil auf einem zweiten Abschnitt der Leiterschicht 82 vorgesehen. Die sich aus einer die emittierten Lichtstrahlen bündelnden Reflektoreinrichtung 5 und einer die emittierten Lichtstrahlen 6a formenden Lichtbündelungsformgebungseinrichtung 7 zusammensetzende Lichtkorrektureinrichtung wird durch Ausformungen des Trägerelements gebildet. Die von der kantenemittierenden Laserdiode 6 emittierten Lichtstrahlen 6a werden zunächst an der Einkoppelfläche 51 der Reflektoreinrichtung 5 in das Material des Trägerelements 2 eingekoppelt und dann an der Reflektions-Fläche 52 der Reflektoreinrichtung - unter Zuhilfenahme der erhöhten Reflexivität der Reflektions-Schicht 5a - in die optische Achse der als sphärischen oder asphärischen Linse ausgebildeten Lichtbündelformgebungseinrichtung 7 gezwungen. Das emittierte Licht 6a wird von der Reflektoreinrichtung 5 von seiner zunächst zur Montage-Oberfläche 2b parallelen Ausbreitungsrichtung durch die im dazu in 45°-Winkel 6b angeordnete Reflektor-Fläche 52 dergestalt reflektiert, dass sie im rechten Winkel zur Austrittsseite 2a des Trägerelements 2 an dieser wieder austritt. Die 45°-Reflektor-Fläche 52 kann bei 100-Wafern als Trägermaterial beispielsweise durch einen Ätzschritt mit Ethylendiamin Pyrocatechol (EDP) geätzt werden. Die 45°-Reflektor-Fläche 52 kann auch durch einen Ätzschritt mit reaktivem Ionen-Ätzen (RIE) erstellt werden. Hierzu müsste ein Fotolack vorher entsprechend, beispielsweise durch Graustufentechnik, belichtet werden. Senkrechte Flächen, wie beispielsweise die Einkoppel-fläche 51, können vermittels sog. Trockenätzen, beispielsweise wieder vermittels reaktivem Ionen-Ätzen, erzeugt werden. Von Vorteil kann die Einkoppelfläche 51 noch mit einer Antireflex-Schicht versehen werden.

Figur 2 zeigt ein noch nicht bestücktes Trägerelement 2, bei dem die sphärische Linse nicht gegenüber der Austrittsseite 2a des Trägerelements 2 aufragend ausgebildet ist, sondern durch Hinwegnahme des Bereichs 2c in die Ebene der Austrittsseite 2a hineingearbeitet ist.

Figur 3 zeigt eine weitere Variante, wobei wieder eine kantenemittierende Laserdiode 6 zum Einsatz kommt, diese ist in sogenannter "Up-Side-Down-Montage" befestigt, bei der die lichtemittierende Kante an der unteren Montageseite des aktiven Halbleiterelements 6 liegt. Die Montage-Oberfläche 2b weist hierbei ein zweites tieferliegendes Niveau 2e auf, da die abgeschrägte Reflektor-Fläche 52 durch das in Höhe der Montage-Oberfläche 2b emittierte Lichtbündel 6a noch getroffen werden muss. Eine Fräs- oder Sägerille 2f dient hierbei der vereinfachten Montage der Laserdiode 6 und der verbesserten Auskopplung des Lichts an der Kante der Laserdiode 6. Ein Vorteil eines solchen Aufbaus besteht darin, dass die Reflektionsstruktur niedrig sein kann und keine weiteren Vorgaben gegenüber der Dicke der Laserdiode 6 gemacht werden müssen, damit die emittierten Lichtstrahlen 6a nach derer Reflektierung in der optischen Achse der Lichtbündelformgebungseinrichtung 7 liegen.

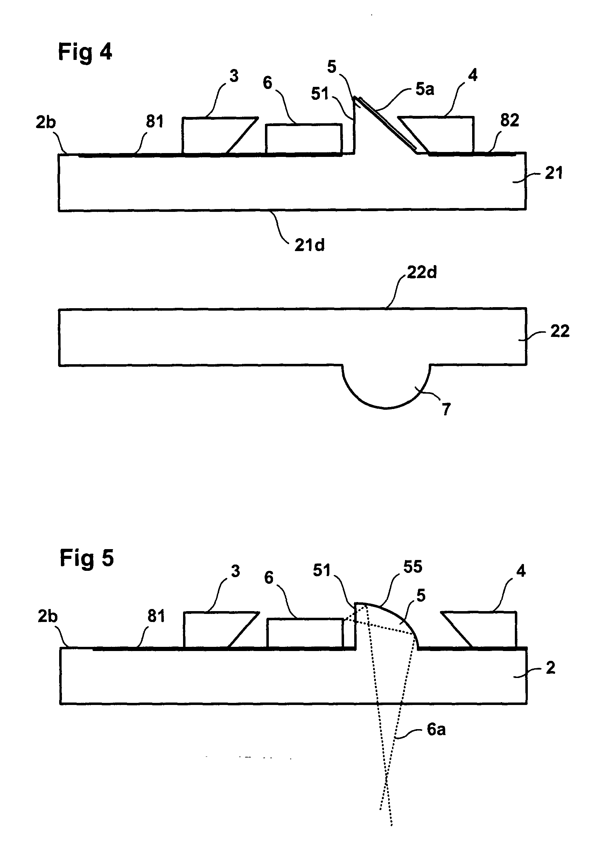

In Figur 4 ist eine Variante des Trägerelements gezeigt, wobei dieses sich aus zwei Teil-Trägern 21 und 22 zusammensetzt, die an ihren gegenüberliegenden glatten ebenen Seitenflächen 21d und 22d miteinander zu verbinden sind. Hierzu kann beispielsweise Siliconfusionbond-Technik oder eine Klebe-Technik zum Einsatz kommen.

In Figur 5 ist eine weitere Variante eines Trägerelements 2 gezeigt, wobei eine gekrümmte Reflektions-Schicht 55 zum Einsatz kommt, wodurch die Lichtbündelungsformgebungseinrichtung 7 in Form einer Linse überflüssig wird. Die Formung erfolgt im Beispiel durch die parabolförmige (elliptische) Ausführung der Reflektoreinrichtung 5 bzw. der Reflektions-Fläche 55.

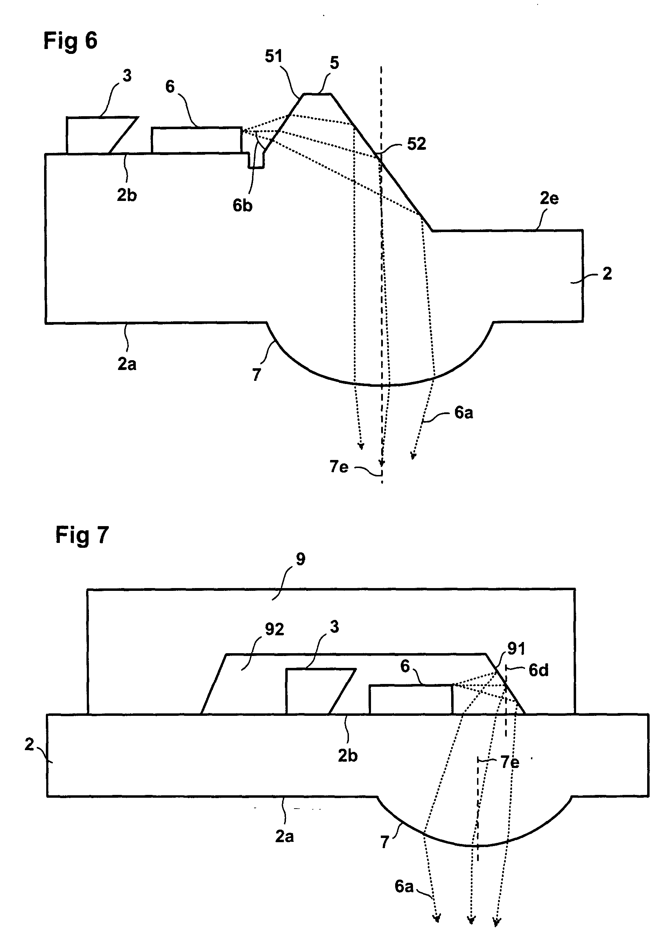

Figur 6 zeigt eine Ausführung eines Trägerelements 2 mit abgeschrägter Einkoppelfläche 51 und in ebenso gleicher Weise abgeschrägter Reflektions-Fläche 52, hierbei können beide Flächen einen Winkel 6b von 54,74° gegenüber der Waagerechten aufweisen. Durch die Anwendung eines 54,74°-Winkels an einer 111-Ebene des Trägermaterials kann zur Herstellung der Schrägen die übliche anisotrope Ätztechnik verwendet werden.

Hierbei wird das von der Lichtquelle 6 emittierte Lichtbündel 6b in Richtung der Lichtbündelformgebungseinrichtung 7 durch eine +54,7°-Einkoppel-Fläche 51 der Reflektoreinrichtung 5 in das optisch transparente Material des Trägerelements 2 bzw. der Reflektoreinrichtung 5 eingekoppelt und an der -54,7°-Reflektions-Fläche 52 der Reflektoreinrichtung 5 in Richtung der Linse 7 reflektiert. Schließlich wird das Lichtbündel 6a durch die integrierte Linsenoberfläche der sphärischen Linse 7 fokussiert. Diese Lichtführung geschieht durch die von 45° abweichenden Grenzflächen nicht mehr in trivialen 90°-Richtungen im Träger-Material sondern in sogenannten off-axis-Richtungen. Hierbei ist die fokussierende Oberfläche der Linse in ihrer Symmetrie-Achse 7e zur Achse des reflektierten Strahles im Trägerelement 2 versetzt, sodass die Hauptabstrahlungsrichtung des fokussierten Strahles einen hierdurch einstellbaren Winkel von 90° +/- x° zur Oberfläche der Austrittsseite 2a haben kann. Die Führung des Lichtweges kann durch Anwendung der einfachen optischen Brechungs- und Reflexionsgesetze vorgegeben werden.

In Figur 7 ist ein lichtemittierendes Halbleiterbauelement gezeigt, bei dem lediglich die Lichtbündelungsformgebungseinrichtung 7 durch die Ausformungen des Trägerelements 2 gebildet ist. Die Reflektoreinrichtung ist hierbei durch eine eine Reflektionsfläche 91 bildende Seitenfläche eines die Komponenten Monitordiode 3 und Laserdiode 6 verkapselnden Verkapselungskörpers 9 gebildet. Der Verkapselungskörper 9 kann erfindungsgemäß als Chip aus einem kristallinen SiliziumSubstrat hergestellt werden, indem der Hohlraum mit einem bekannten anisotropen Ätzverfahren hergestellt ist, das für die reflektierende Oberfläche einen Winkel von 54,7° in ausreichender optischer Qualität liefert. In diesem Fall trifft das Licht nicht mehr senkrecht auf die Oberfläche 2a und wird damit entsprechend den Angaben zu Figur 6 durch den entsprechenden Versatz der Symmetrieachse 6d und der Symmetrieachse 7e der Linse 7 in die vorgegebene Richtung 90° +/- x° zur Oberfläche der Austrittsseite 2a abgebildet. Der Verkapselungskörper 9 schließt hierbei die Komponenten in einem Hohlraum 92 ein. Wie schon in Figur 6 wird der nicht rechtwinklige Auftreffwinkel auf die Austrittsfläche 2a des Trägerelements 2 durch einen Versatz der optischen Achse 7e der Lichtbündelungskorrektureinrichtung 7 gegenüber der optischen Achse 6d der Reflektionsfläche 91 ausgeglichen.

Bezugszeichenliste
- 1: lichtemittierendes Halbleiterbauelement
- 2: Trägerelement
- 2a: Austrittsseite
- 2b: Montage-Oberfläche
- 2c: weggenommener Bereich
- 2d: Trennlinie
- 2e: tiefer liegende Montage-Oberfläche
- 2f: Fräsrille
- 21, 22: Teil-Träger
- 21d, 22d: plane Seitenfläche der Teil-Träger

- 3, 4: Monitordiode

- 5: Reflektoreinrichtung
- 51: Einkoppel-Fläche
- 52: Reflektions-Fläche
- 55: elliptische Reflektions-Fläche
- 5a: Reflektions-Schicht

- 6: aktives Halbleiterelement
- 6a: Lichtstrahlen
- 6b: Winkel
- 6d: optische Achse

- 7: Lichtbündelformgebungseinrichtung
- 7e: optische Achse, Symmetrieachse

- 81, 82: leitende Schicht

- 9: Verkapselungskörper
- 91: Reflektionsfläche
- 92: Hohlraum

## Patentansprüche

1. Lichtemittierendes Halbleiterbauelement (1) mit einem lichterzeugenden oder empfangenden aktiven Halbleiterelement (6), bei dem das auszusendende oder zu empfangende Lichtbündel (6a) vermittels einer Lichtkorrektureinrichtung (5 und 7) geformt ist, und das aktive Halbleiterelement auf einer Montage-Oberfläche (2b) eines das Halbleiterelement abstützenden Trägerelements (2) befestigt ist,
**dadurch gekennzeichnet,**
**dass** das Trägerelement (2) aus einem kristallinen, insbesondere einem einkristallinen Material besteht und die Lichtkorrektureinrichtung (5 und 7) durch von dem auszusendenden oder zu empfangenden Lichtbündel zu durchstrahlenden Ausformungen des Trägerelements (2) selbst gebildet ist.

2. Lichtemittierendes Halbleiterbauelement nach Anspruch 1,
**dadurch gekennzeichnet,**
**dass** die Lichtkorrektureinrichtung ein die emittierten Lichtstrahlen (6a) reflektierende und/oder bündelnde Reflektoreinrichtung (5, 52, 5a) aufweist.

3. Lichtemittierendes Halbleiterbauelement nach Anspruch 1 oder 2,
**dadurch gekennzeichnet,**
**dass** die Lichtkorrektureinrichtung ein die emittierten oder empfangenen Lichtstrahlen (6a) formende und/oder bündelnde Lichtbündelformgebungseinrichtung (7) aufweist.

4. Lichtemittierendes Halbleiterbauelement nach Anspruch 3,
**dadurch gekennzeichnet,**
**dass** die Lichtbündelformgebungseinrichtung eine Linse (7), insbesondere eine sphärische oder asphärische Linse ist.

5. Lichtemittierendes Halbleiterbauelement nach einem der Ansprüche 2 bis 4,
**dadurch gekennzeichnet,**
**dass** die Reflektoreinrichtung (5) das emittierte Lichtbündel (6a) in das Material des Trägerelements einkoppelt und eine dergestalt angeschrägte Reflektions-Fläche (52) aufweist, dass das Lichtbündel (6a) durch das Trägerelement (2) hindurch strahlt.

6. Lichtemittierendes Halbleiterbauelement nach einem der Anspruch 5,
**dadurch gekennzeichnet,**
**dass** die Reflektions-Fläche (52) dergestalt geformt ist, dass das Lichtbündel (6a) durch das Trägerelement (2) hindurch und durch die Lichtbündelformgebungseinrichtung (7) strahlt.

7. Lichtemittierendes Halbleiterbauelement nach einem der Ansprüche 2 bis 6,
**dadurch gekennzeichnet,**
**dass** die Reflektoreinrichtung (5) das emittierte Lichtbündel (6a) in das Material des Trägerelements einkoppelt und eine dergestalt geformte Reflektions-Fläche (55) aufweist, dass das Lichtbündel (6a) durch das Trägerelement (2) hindurch strahlt und in seiner Form verändert wird.

8. Lichtemittierendes Halbleiterbauelement nach einem der Anspruch 7,
**dadurch gekennzeichnet,**
**dass** die Reflektions-Fläche (55) eine elliptische oder parabolische Formgebung hat.

9. Lichtemittierendes Halbleiterbauelement nach einem der Ansprüche 2 bis 8,
**dadurch gekennzeichnet,**
**dass** die Reflektoreinrichtung (5) eine gegenüber der Montage-Oberfläche (2b) angeschrägte Einkoppelfläche (51) aufweist.

10. Lichtemittierendes Halbleiterbauelement nach einem der Anspruch 9,
**dadurch gekennzeichnet,**
**dass** die angeschrägte Einkoppelfläche (51) einen Winkel (6b) von 54,74° gegenüber der Ausbreitungsrichtung des emittierten Lichtbündels (6a) aufweist.

11. Lichtemittierendes Halbleiterbauelement nach einem der vorhergehenden Ansprüche,
**dadurch gekennzeichnet,**
**dass** die angeschrägte Reflektions-Fläche (52) einen Winkel (6b) von 54,74° oder 45° gegenüber der Ausbreitungsrichtung des emittierten Lichtbündels (6a) aufweist.

12. Lichtemittierendes Halbleiterbauelement nach einem der vorhergehenden Ansprüche,
**dadurch gekennzeichnet,**
**dass** die angeschrägte Reflektions-Fläche (52) mit einer den Reflektionsgrad erhöhenden Reflektions-Schicht (5a) überzogen ist.

13. Lichtemittierendes Halbleiterbauelement nach einem der Ansprüche 1 bis 12,
**dadurch gekennzeichnet,**
**dass** das aktive Halbleiterelement (6) eine lichtemittierende Diode, insbesondere eine seitenemittierende Laser-Diode ist.

14. Lichtemittierendes Halbleiterbauelement nach Anspruch 1 bis 13,
**dadurch gekennzeichnet,**
**dass** eine auf oder in dem Trägerelement (2) ausgebildete Monitordiode (3, 4) zur Betriebsüberwachung des aktiven Halbleiterelements (6) vorgesehen ist.

15. Lichtemittierendes Halbleiterbauelement nach Anspruch 1 bis 14,
**dadurch gekennzeichnet,**
**dass** das Trägerelement (2) aus zwei flächig miteinander verbundenen jeweils Teile der Lichtkorrektureinrichtung (5 oder 7) aufweisenden Teil-Trägern (21 und 22) besteht.

16. Verfahren zur Herstellung eines Trägerelements (2) für ein lichtemittierendes oder -empfangendes Halbleiterbauelement (6) insbesondere nach einem der Ansprüche 1 bis 15,
**dadurch gekennzeichnet,**
**dass** aus dem Material des Trägerelements (2) eine gegenüber der Oberfläche (2b, 2a) des Trägerelements (2) aufragende und/oder in die Oberfläche (2b, 2a) des Trägerelements hineinragende und von dem emittierenden oder -empfangenen Lichtbündel (6a) zu durchstrahlende Lichtkorrektureinrichtung (5 und 7) ausgeformt wird.

17. Verfahren zur Herstellung eines Trägerelements nach Anspruch 16,
**dadurch gekennzeichnet,**
**dass** als Material für das Trägerelement (2) ein kristallines insbesondere ein einkristallines Material verwendet wird.

18. Verfahren zur Herstellung eines Trägerelements nach Anspruch 16 oder 17,
**dadurch gekennzeichnet,**
**dass** die die Lichtkorrektureinrichtung (5 und 7) bildenden Ausformungen durch bereichsweises Wegätzen eines Grundträgers, insbesondere einer zwei planparallele Seiten aufweisenden Platte oder Scheibe, vermittels eines nasschemischen Ätzprozesses und/oder eines reaktiven Ionen-Ätz-Prozesses hergestellt werden.

19. Verfahren zur Herstellung eines Trägerelements nach Anspruch 18,
**dadurch gekennzeichnet,**
**dass** die Lackschichten zur Maskierung des Ätzprozesses in Graustufenfotolacktechnik erstellt werden.

20. Verfahren zur Herstellung eines Trägerelements nach Anspruch 18 oder 19,
**dadurch gekennzeichnet,**
**dass** eine Montage-Oberfläche (2b) zur Abstützung eines darauf zu befestigenden lichterzeugenden oder empfangenden aktiven Halbleiterelements (6) gleichzeitig mit der Lichtkorrektureinrichtung (5 und 7) gefertigt wird.

21. Verfahren zur Herstellung eines Trägerelements nach einem der Ansprüche 16 bis 20,
**dadurch gekennzeichnet,**
**dass** die Oberfläche (52) der Lichtkorrektureinrichtung (5 und 7) wenigstens teilweise mit einer den Reflektionsgrad erhöhenden Reflektionsschicht (5a) insbesondere aus Metall oder mehreren dielektrischen Schichten überzogen wird.

22. Verfahren zur Herstellung eines Trägerelements nach einem der Ansprüche 16 bis 21,
**dadurch gekennzeichnet,**
**dass** die Reflektionseinrichtung durch eine Reflektions-Oberfläche (91) eines Verkapselungskörpers (9) gebildet wird, der die Monitordiode (3) und das aktive Halbleiterelement (6) in einem Hohlraum (92) einschließt.

23. Verfahren zur Herstellung eines Trägerelements nach einem der Ansprüche 16 bis 22,
**dadurch gekennzeichnet,**
**dass** als Material des Verkapselungskörper (9) kristallines Material, insbesondre Silizium, verwendet wird.

24. Verfahren zur Herstellung eines Trägerelements nach Anspruch 23,
**dadurch gekennzeichnet,**
**dass** die Reflexions-Oberfläche (91) und/oder der Hohlraum (92) durch anisotropes Ätzen hergestellt wird.

25. Verfahren zur Herstellung eines Trägerelements nach Anspruch 24,
**dadurch gekennzeichnet,**
**dass** die Reflexions-Oberfläche (91) mit einer reflexionssteigernden dielektrischen oder metallischen Schichtfolge wenigstens teilweise überzogen wird.

26. Verfahren zur Herstellung eines Trägerelements nach einem der Ansprüche 16 bis 25,
**dadurch gekennzeichnet,**
**dass** die Reflexions-Oberfläche (91) des Verkapselungskörpers (9) mit einen Reflexionswinkel von 45° hergestellt wird.
